# FASCICULE DE BREVET EUROPEEN

(11) **EP 1 953 778 B1**
(45) Date de publication et mention de la délivrance du brevet: **16.05.2012**
(21) Numéro de dépôt: 08101038.1
(22) Date de dépôt: 29.01.2008
(51) Int. Cl.: H01G 4/38

(54) **Condensateur dans un circuit monolithique**
Kondensator in einem Festkörperschaltkreis
Condenser in a monolithic circuit

(30) Priorité: 31.01.2007 FR 0752981
(43) Date de publication de la demande: 06.08.2008
(73) Titulaire: STMICROELECTRONICS S.A., 92120 Montrouge (FR)
(72) Inventeur: Gardes, Pascal, 37100 Tours (FR); Blanchard, Stéphane, 439852 Singapore (SG); Boufnichel, Mohamed, 37380 Monnaie (FR)
(74) Mandataire: de Beaumont, Michel

(56) Documents cités:
- FR-A- 2 884 646
- JP-A- 1 189 949
- US-A1- 2003 183 862

## Description

### Domaine de l'invention

La présente invention concerne de façon générale les circuits intégrés et autres circuits monolithiques, et plus particulièrement un condensateur formé dans de tels circuits.

### Exposé de l'art antérieur

De façon classique, dans le domaine des circuits intégrés, un condensateur est formé entre des couches de métallisation parallèles à la surface d'un substrat. On parle alors de condensateur bidimensionnel. Pour augmenter la capacité par unité de surface du condensateur, on a imaginé des condensateurs tridimensionnels. De tels condensateurs sont par exemple utilisés dans des circuits haute fréquence, et trouvent notamment des applications dans des circuits de téléphones portables. Les demandes de brevet FR 2884646 et US 2003/183862 présentent divers procédés de formation de condensateurs tridimensionnels.

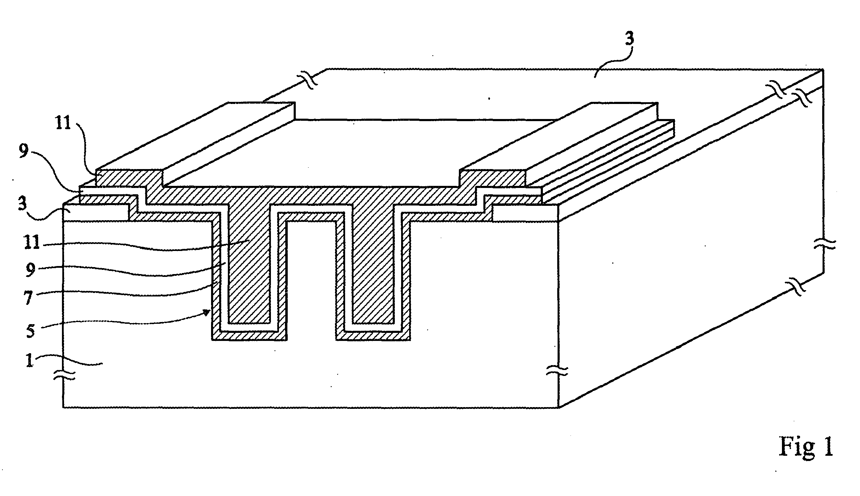

La figure 1 représente en perspective un exemple de condensateur tridimensionnel. Une zone active sur un substrat 1 est délimitée par une ouverture dans une couche isolante 3. A l'intérieur de cette zone active, des rainures 5 sont formées dans le substrat.

Une couche conductrice 7 s'étend sur le substrat 1 et sur les parois et le fond des rainures 5. Une couche isolante 9 s'étend sur la couche conductrice 7 et pénètre également dans les rainures 5. Une seconde couche conductrice 11 s'étend sur la couche isolante 9 et pénètre également dans les rainures 5.

La couche conductrice 11 constitue une première électrode du condensateur, et la couche conductrice 7 constitue une seconde électrode du condensateur. Des contacts non représentés sont pris sur ces électrodes.

La capacité d'un condensateur est donnée par la formule E.S/d, E étant la permittivité de la couche isolante entre les électrodes, S la surface des électrodes en regard et d l'épaisseur de la couche isolante. Un objectif récurrent dans la réalisation de condensateurs est d'augmenter la valeur de leur capacité, sans pour autant augmenter leur surface dans un plan parallèle à la surface principale d'un substrat. Trois options sont possibles pour atteindre cet objectif : diminuer l'épaisseur de l'isolant d, augmenter la valeur de la permittivité ε de l'isolant, et augmenter la surface dans un plan vertical. Ces options ont cependant leurs limites, que ce soit pour des condensateurs bidimensionnels ou tridimensionnels.

En effet, la diminution de l'épaisseur de la couche isolante est limitée si on veut éviter une dégradation des propriétés électriques du condensateur, à savoir en particulier une diminution de sa tension de claquage et une augmentation de son courant de fuite.

Le remplacement du matériau de la couche isolante par un matériau de permittivité ε plus importante pose également problème. En effet, ce remplacement peut provoquer des incompatibilités avec les autres éléments du condensateur, et la fabrication toute entière de celui-ci peut être à modifier en conséquence.

Dans le cas de condensateurs tridimensionnels, on pourrait augmenter la surface S des électrodes en regard en augmentant la profondeur des rainures creusées dans le substrat. Cependant, une augmentation excessive de la profondeur des rainures fragilise la structure du dispositif. De plus, il est toujours long et difficile d'augmenter la profondeur d'évidements formés dans un substrat.

Les différentes solutions proposées ci-dessus pour augmenter la valeur de la capacité par unité de surface présentent toutes des inconvénients.

### Résumé de l'invention

La présente invention vise à réaliser un condensateur ayant une capacité importante par unité de surface, en évitant au moins certains des inconvénients liés aux structures du type représenté en figure 1.

Pour atteindre tout ou partie de ces objets tel que defini dans la revendication 1, un mode de réalisation de la présente invention prévoit un condensateur comprenant, sur un substrat : une succession de couches conductrices séparées par des couches isolantes ; et des première et deuxième bornes ; dans lequel les couches conductrices et isolantes s'étendent sur le substrat et dans des portions évidées du substrat, la première borne étant reliée aux couches conductrices d'ordre pair et la seconde borne étant reliée aux couches conductrices d'ordre impair.

Selon un mode de réalisation de la présente invention, le condensateur comprend une première couche conductrice ; une première couche isolante ; une deuxième couche conductrice ; une seconde couche isolante ; une troisième couche conductrice ; une première borne reliée à la deuxième couche conductrice ; et une seconde borne reliée aux première et troisième couches conductrices.

Selon un mode de réalisation de la présente invention, les portions évidées sont des rainures de section rectangulaire.

Selon un mode de réalisation de la présente invention, les couches conductrices sont en silicium polycristallin dopé.

Selon un mode de réalisation de la présente invention, les couches isolantes sont en nitrure de silicium.

Selon un mode de réalisation de la présente invention, le substrat est un substrat semiconducteur tel que du silicium.

Selon un mode de réalisation de la présente invention, le condensateur est formé dans un caisson d'un substrat semiconducteur.

Selon un mode de réalisation de la présente invention, le condensateur comprend en outre une métallisation supérieure dont une partie est reliée par des premiers via aux couches conductrices d'ordre pair et par des deuxièmes via aux couches conductrices d'ordre impair.

### Brève description des dessins

Ces objets, caractéristiques et avantages, ainsi que d'autres seront exposés en détail dans la description suivante de modes de réalisation particuliers de la présente invention faite à titre non-limitatif en relation avec les figures jointes parmi lesquelles :
la figure 1, précédemment décrite, représente une vue en perspective d'un exemple de condensateur ;
la figure 2 est une vue en coupe d'un condensateur selon un mode de réalisation de l'invention ; et
la figure 3 est une vue de dessus du condensateur de la figure 2 représentant un exemple de structure des bornes du condensateur selon un mode de réalisation de l'invention.

### Description détaillée

Comme cela est habituel dans la représentation des composants électroniques, les diverses figures ne sont pas tracées à l'échelle.

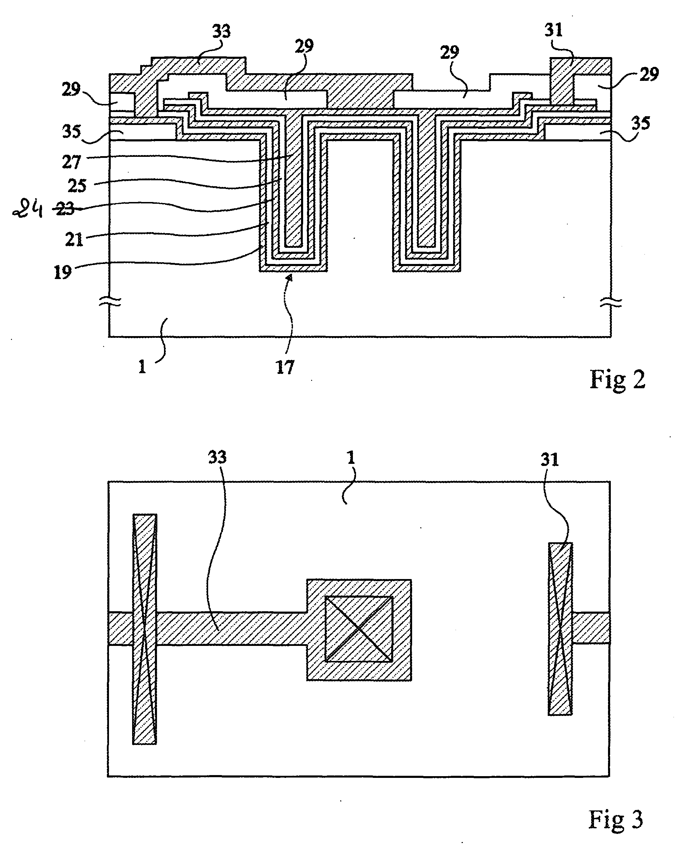

La figure 2 est une vue en coupe d'un condensateur selon un mode de réalisation de l'invention. Un substrat 1 comporte des portions évidées 17, par exemple des rainures, de forme sensiblement rectangulaire. Une première couche conductrice 19 s'étend sur le substrat 1 et sur les parois et le fond des rainures 17. Une couche isolante 21 s'étend sur la couche conductrice 19, une deuxième couche conductrice 24 s'étend sur la couche isolante 21, une couche isolante 25 s'étend sur la couche conductrice 24 et une troisième couche conductrice 27 s'étend sur la couche isolante 25 ; les couches 21, 24, 25 et 27 pénètrent également dans les rainures 17.

Un premier condensateur est formé par les première et deuxième couches conductrices 19 et 24 séparées par la couche isolante 21, et un deuxième condensateur est formée par les deuxième et troisième couches conductrices 24 et 27 séparées par la couche isolante 25. La deuxième couche conductrice 24 constitue donc une plaque commune aux deux condensateurs ainsi formés. Ces deux condensateurs sont connectés en parallèle pour fournir un condensateur unique ayant pour capacité la somme des capacités élémentaires. La deuxième couche conductrice 24 est connectée à une première borne de connexion et les première et troisième couches conductrices 19 et 27 sont connectées à une seconde borne de connexion, ce qui réalise la connexion parallèle.

Les figures 2 et 3 illustrent une façon de réaliser la mise en parallèle de ces deux condensateurs. Les couches formant le condensateur sont revêtues d'une couche isolante 29. Une première région conductrice 31 correspondant à la première borne est placée sur la couche isolante 29 et est connectée à la deuxième couche conductrice 24 par l'intermédiaire d'un via traversant les couches isolantes 25 et 29. Une seconde région conductrice 33 correspondant à la seconde borne est placée sur la couche isolante 29 et est connectée à la première couche conductrice 19 par l'intermédiaire d'un via traversant les couches isolantes 21 et 29 et à la troisième couche conductrice 27 par l'intermédiaire d'un via traversant la couche isolante 29.

La vue de dessus de la figure 3 représente un exemple de topographie des régions conductrices 31 et 33. Les zones de contact entre les régions conductrices 31 et 33 et les couches conductrices 19, 24 et 27 sont marquées d'une croix. La zone de contact entre la région conductrice 31 et la couche conductrice 24 s'étend sensiblement sur la longueur des rainures 17. De façon identique, la zone de contact entre la région conductrice 33 et la couche conductrice 19 s'étend sensiblement sur la longueur des rainures 17, tandis que la zone de contact entre la couche 27 et la borne 31 a la forme d'un carré.

Divers matériaux et associations de matériaux pourront être utilisés pour réaliser un condensateur selon un mode de réalisation de la présente invention :
- le substrat 1 peut être un substrat isolant tel que du verre ou un substrat semiconducteur tel que du silicium. Dans le cas d'un substrat présentant une conductivité non négligeable, on pourra prévoir une couche isolante sur le substrat et dans les portions évidées pour isoler la première couche conductrice de ce substrat. Si le substrat est en silicium, on pourra prévoir que la zone active dans laquelle sont formées les rainures est un caisson de type de conductivité opposé à celui du reste du substrat ;
- les couches conductrices 19, 24 et 27 peuvent être en silicium polycristallin dopé ou être constituées de métallisations ;
- les couches isolantes seront par exemple en nitrure de silicium ou en oxyde de silicium, mais pourront être en tout autre matériau compatible avec le processus de fabrication utilisé.

Ci-après, des exemples de valeurs numériques d'épaisseurs des différentes couches selon un mode de réalisation de l'invention sont donnés :
- la première couche conductrice 19 peut avoir une épaisseur comprise entre 50 et 200 nm, la deuxième couche conductrice 24 une épaisseur comprise entre 50 et 500 nm, et la troisième couche conductrice 27 une épaisseur comprise entre 120 nm et 1 µm ; et
- les couches isolantes 21 et 25 peuvent être des couches de nitrure de silicium d'une épaisseur comprise entre 20 et 80 nm.

A titre d'exemple plus précis, dans le cas de rainures ayant une largeur de 0,8 µm, de couches conductrices en silicium polycristallin dopé et de couches isolantes en nitrure de silicium, on pourra choisir pour les épaisseurs des diverses couches les valeurs suivantes :
- première couche conductrice 19 : 100 nm
- deuxième couche conductrice 24 : 100 nm
- couches isolantes 21 et 25 : 50 nm
- troisième couche conductrice : 100 nm, cette troisième couche conductrice remplissant l'espace restant dans les rainures 17.

Des rainures d'une largeur d'environ 0,8 µm sont donc bien adaptées à la formation d'un condensateur selon un mode de réalisation de l'invention. Or, les condensateurs de l'art antérieur, comme celui représenté en figure 1, sont souvent formés dans des rainures de profondeur comprise entre 20 µm et 100 µm, pour lesquelles les techniques de fabrication courantes conduisent à des largeurs de l'ordre de 0,7 µm à 1 µm. Ces procédés, connus et faciles à mettre en oeuvre, permettent donc d'obtenir des rainures de largeurs adaptées à la réalisation d'un condensateur selon un mode de réalisation de la présente invention. Ceci constitue un avantage de la présente invention :
la réalisation de condensateurs du type décrit ci-dessus n'implique pas de modification des moyens courants de formation de rainures dans un substrat, et ne nécessite que des moyens connus de dépôt de couches conductrices et isolantes. La réalisation de condensateurs comprenant trois plaques conductrices n'implique donc pas de procédé de fabrication plus complexe que la réalisation de condensateurs tridimensionnels classiques constitués uniquement de deux plaques conductrices. Ainsi, un condensateur à trois couches conductrices selon un mode de réalisation de la présente invention occupera en pratique la même surface de substrat qu'un condensateur classique à deux couches, alors qu'il aura une capacité sensiblement double.

On a illustré à titre d'exemple un condensateur formé sur une zone active définie par une ouverture dans une couche isolante 35. Cette couche 35 permet également, dans le cas où un substrat de conductivité non négligeable est utilisé, d'isoler électriquement les bornes 31 et 33 du substrat 1.

La troisième couche conductrice 27 a été décrite précédemment comme remplissant entièrement l'espace situé au-dessus de la couche 25 dans les rainures 17. Selon une variante de réalisation de la présente invention, la couche conductrice 27 est déposée sur la couche isolante 25 de façon suffisamment épaisse pour le bon fonctionnement du condensateur mais elle ne remplit pas tout l'espace restant dans les rainures 17 au-dessus de la couche isolante 25. L'espace restant est alors comblé par un matériau de remplissage adapté.

La présente invention a été décrite ci-dessus en considérant un condensateur formé de deux condensateurs élémentaires en parallèle, c'est-à-dire un dispositif comprenant trois couches conductrices isolées. On notera que le nombre de condensateurs élémentaires mis en parallèle pour constituer le condensateur principal peut être supérieur à deux. En effet, d'autres couches conductrices et isolantes peuvent être ajoutées sur les couches conductrices et isolantes décrites en relation avec la figure 2 pour créer d'autres condensateurs élémentaires. La mise en parallèle de ce ou ces nouveaux condensateurs élémentaires avec ceux déjà formés est réalisée en reliant de façon adéquate les différentes couches conductrices. L'utilisation de trois condensateurs ou plus en parallèle permet d'augmenter la capacité par unité de surface du condensateur et peut nécessiter une augmentation de la largeur des rainures. L'utilisation du condensateur comprenant trois condensateurs élémentaires est donc intéressante si on désire avoir une capacité par unité de surface importante. Une structure à plus de trois condensateurs élémentaires en parallèle peut également être envisagée et permet, de la même façon que décrit précédemment, d'obtenir une capacité par unité de surface importante.

La présente invention a été présentée comme permettant d'obtenir, sur une surface donnée d'un substrat, un condensateur de capacité élevée par la mise en parallèle de plusieurs condensateurs élémentaires ; en effet, sur une même surface, un condensateur comprenant deux condensateurs élémentaires permet d'obtenir une capacité sensiblement double à celle obtenue par un condensateur unique. Au lieu d'augmenter la capacité obtenue par unité de surface, l'invention permet également d'obtenir, avec un système à trois couches conductrices, la même valeur de capacité qu'un système à deux couches conductrices mais en formant des rainures sensiblement deux fois moins profondes. Ceci permet d'éviter la formation de rainures profondes, qui sont généralement plus difficiles et plus longues à réaliser.

Le condensateur selon un mode de réalisation de la présente invention a également été présenté comme étant créé à partir de rainures ayant des formes rectangulaires. Les évidements dans le substrat peuvent également prendre tout type de forme, comme par exemple des ouvertures de sections circulaires, hexagonales, ou autres, pour autant que les dimensions de ces ouvertures permettent la formation des différentes couches conductrices et isolantes nécessaires à la réalisation d'un condensateur selon un mode de réalisation de l'invention.

## Revendications

1. Condensateur comprenant, sur un substrat (1), une succession de couches conductrices (19, 24, 27), alternativement d'ordre pair et d'ordre impair, séparées par des couches isolantes (21, 25) et comprenant des première et deuxième bornes (31, 33), **caractérisé en ce que** les couches conductrices (19, 24, 27) et isolantes (21, 25) s'étendent sur le substrat (1) et dans des portions évidées (17) du substrat (1), la première borne (31) étant reliée aux couches conductrices d'ordre pair (24) et la seconde borne (33) étant reliée aux couches conductrices d'ordre impair (19, 27).

2. Condensateur selon la revendication 1, comprenant :
une première couche conductrice (19) ;
une première couche isolante (21) ;
une deuxième couche conductrice (24);
une seconde couche isolante (25) ;
une troisième couche conductrice (27) ;
une première borne (31) reliée à la deuxième couche conductrice (24); et
une seconde borne (33) reliée aux première (19) et troisième (27) couches conductrices.

3. Condensateur selon la revendication 1 ou 2, dans lequel les portions évidées (17) sont des rainures de section rectangulaire.

4. Condensateur selon l'une quelconque des revendications 1 à 3, dans lequel les couches conductrices (19, 24, 27) sont en silicium polycristallin dopé.

5. Condensateur selon l'une quelconque des revendications 1 à 4, dans lequel les couches isolantes (21, 25) sont en nitrure de silicium.

6. Condensateur selon l'une quelconque des revendications 1 à 5, dans lequel le substrat (1) est un substrat semiconducteur tel que du silicium.

7. Condensateur selon l'une quelconque des revendications 1 à 6, formé dans un caisson d'un substrat semiconducteur.

8. Condensateur selon l'une quelconque des revendications 1 à 7, comprenant en outre une métallisation supérieure dont une partie est reliée par des premiers via aux couches conductrices d'ordre pair et par des deuxièmes via aux couches conductrices d'ordre impair.

## Claims

1. A capacitor comprising, on a substrate (1), a succession of conductive layers (19, 24, 27), alternately of even order and of odd order, separated by insulating layers (21, 25) and comprising first and second terminals (31, 33), **characterized in that** the conductive (19, 24, 27) and insulating (21, 25) layers extend on the substrate (1) and in recessed portions (17) of the substrate (1), the first terminal (31) being connected to the conductive layers of even order (24) and the second terminal (33) being connected to the conductive layers of odd order (19, 27).

2. The capacitor of claim 1, comprising:
a first conductive layer (19);
a first insulating layer (21);
a second conductive layer (24);
a second insulating layer (25);
a third conductive layer (27);
a first terminal (31) connected to the second conductive layer (24); and
a second terminal (33) connected to the first (19) and third (27) conductive layers.

3. The capacitor of claim 1 or 2, wherein the recessed portions (17) are grooves of rectangular cross-section.

4. The capacitor of any of claims 1 to 3, wherein the conductive layers (19, 24, 27) are made of doped polysilicon.

5. The capacitor of any of claims 1 to 4, wherein the insulating layers (21, 25) are made of silicon nitride.

6. The capacitor of any of claims 1 to 5, wherein the substrate (1) is a semiconductor substrate such as silicon.

7. The capacitor of any of claims 1 to 6, formed in a well of a semiconductor substrate.

8. The capacitor of any of claims 1 to 7, further comprising an upper metallization having a portion connected by first vias to the conductive layers of even order and by second vias to the conductive layers of odd order.

## Patentansprüche

1. Ein Kondensator, der Folgendes aufweist: auf einem Substrat (1) eine Folge von leitenden Schichten (19, 24, 27) abwechselnd von geradzahliger Ordnung und ungeradzahliger Ordnung getrennt durch Isolierschichten (21, 25) und erste und zweite Anschlüsse (31, 33) aufweisend, **dadurch gekennzeichnet, dass** die leitenden (19, 24, 27) und isolierenden (21, 25) Schichten sich auf dem Substrat (1) erstrecken und zwar in Ausnehmungsteilen (17) des Substrats (1) wobei der erste Anschluss (31) mit den leitenden Schichten geradzahliger Ordnung (24) und der zweite Anschluss (33) mit den leitenden Schichten ungeradzahliger Ordnung (19, 27) verbunden sind.

2. Der Kondensator nach Anspruch 1, wobei Folgendes vorgesehen ist:
eine erste leitende Schicht (19);
eine erste Isolierschicht (21);
eine zweite leitende Schicht (24);
eine zweite Isolierschicht (25);
eine dritte leitende Schicht (27);
einen ersten Anschluss (31) verbunden mit der zweiten leitenden Schicht (24); und
einen zweiten Anschluss (33) verbunden mit der ersten leitenden Schicht (19) und der dritten leitenden Schicht (27).

3. Der Kondensator nach Anspruch 1 oder 2, wobei die Ausnehmungsteile (17) Nuten von rechteckigem Querschnitt sind.

4. Der Kondensator nach einem der Ansprüche 1 bis 3, wobei die leitenden Schichten (19, 24, 27) aus dotierem Polysilizium hergestellt sind.

5. Der Kondensator nach einem der Ansprüche 1 bis 4, wobei die isolierenden Schichten (21, 25) aus Siliziumnitrid hergestellt sind.

6. Der Kondensator nach einem der Ansprüche 1 bis 5, wobei das Substrat (1) ein Halbleitersubstrat wie beispielsweise Silizium ist.

7. Der Kondensator nach einem der Ansprüche 1 bis 6, ausgebildet in einer Vertiefung eines Halbleitersubstrats.

8. Der Kondensator nach einem der Ansprüche 1 bis 7, wobei ferner eine obere Metallisierung vorgesehen ist und zwar mit einem Teil verbunden durch erste Vias mit den leitenden Schichten geradzahliger Ordnung und durch zweite Vias mit den leitenden Schichten ungeradzahliger Ordnung.
